(19)

Europäisches
Patentamt

European
Patent Office

Office européen
des brevets

(11) **EP 2 682 989 A1**

(12) **EUROPEAN PATENT APPLICATION**
published in accordance with Art. 153(4) EPC

(43) Date of publication:
   **08.01.2014 Bulletin 2014/02**

(21) Application number: **11859732.7**

(22) Date of filing: **08.12.2011**

(51) Int Cl.:
   **H01L 29/74** (2006.01)   **H01L 21/332** (2006.01)

(86) International application number:
   **PCT/CN2011/083710**

(87) International publication number:
   **WO 2012/116566 (07.09.2012 Gazette 2012/36)**

(84) Designated Contracting States:
   **AL AT BE BG CH CY CZ DE DK EE ES FI FR GB
   GR HR HU IE IS IT LI LT LU LV MC MK MT NL NO
   PL PT RO RS SE SI SK SM TR**

(30) Priority: **28.02.2011 CN 201110051556
   11.04.2011 CN 201110089026**

(71) Applicant: **Cheng Dian Intelligent-Power
   Microelectronics
   Design Co., Ltd. of Chengdu
   Sichuan 611731 (CN)**

(72) Inventor: **CHEN, Xingbi
   Chengdu
   Sichuan 610054 (CN)**

(74) Representative: **Santarelli
   14, avenue de la Grande Armée
   Boîte Postale 237
   75822 Paris Cedex 17 (FR)**

(54) **THYRISTOR FOR CONTROLLING TWO TYPES OF CHARGE CARRIERS**

(57)   A thyristor for controlling two types of charge carriers. Two controllable current sources (200, 300) are utilized to control an electron current and a hole current when a voltage resistance region of the thyristor conducts, so that the total current between the anode and the cathode of the thyristor tends to be saturated under a high voltage, thereby avoiding the current concentration effect in individual regions and improving the reliability of the thyristor. A method for implementing the two controllable current sources (200, 300) in the thyristor, and methods for accelerating an on-to-off process and an off-to-on process of the thyristor are all provided.

(a)

(b)

FIG. 13

EP 2 682 989 A1

## Description

### FIELD OF THE INVENTION

The present invention relates to a semiconductor device, particularly to a high power device.

### BACKGROUND OF THE INVENTION

Normally, vertical high-voltage semiconductor devices require semiconductor material with high resistivity to serve as voltage-sustaining regions.

It is well-known that the on-state voltage drop across the voltage-sustaining region with high resistivity in the devices such as thyristor, GTO (Gate Turn-Off Thyristor), MCT (MOS Controlled Thyristor) has been decreased greatly due to the excess carriers.

When an external signal is applied to turn off the GTO and MCT, the effect of current crowding always arises and causes the devices to be destroyed. Because the regeneration effect is utilized in these devices, when the voltage of each part or cell has subtle enhancement, the current of this part or cell would increase sharply, causing current crowding. Therefore the reliability of devices is reduced greatly.

### References:

[1] X. B. Chen, U. S. Patent, Appl. No. 12/712,583(2010), or Chinese patent ZL 200910119961.3.
[2] X. B. Chen, U. S. Patent, 5,726,469.A, or Chinese patent ZL 95108317.1.
[3] X. B. Chen, Chinese Patent ZL 201010000034.2.

### SUMMARY OF THE INVENTION

The object of this invention is:

1. In the steady on-state of the thyristor, the current from one terminal to another terminal of the device increases sharply with the increasing of the external voltage applied across the two terminals starting from a very low voltage; but with further  increasing of the external voltage, the current tends to be saturated. Such saturated current varies with the change of the voltage of the signal, which controls the conduction of the device.
2. In the stage from the off-state to the on-state of the device, there is no current crowding effect during the switching time.
3. In the stage from the on-state to off-state of the device, there is no current crowding effect during the switching time.
4. During turning-off, the decrease of both types of carriers in the voltage-sustaining region is realized by eliminating the injection of both types of carriers into the voltage-sustaining region (drift region). Such method can achieve fast turn-off.

The present invention can be summarized by referring the preferred embodiments described as follows.

1. According to the present invention, a semiconductor device is provided. Its operation region is located between a first main surface (the top surface of the semiconductor in each figure showing the structure) and a second main surface (the bottom surface of the semiconductor in each figure showing the structure) of a semiconductor, comprising cell(s) of a first kind and/or cell(s) of a second kind and/or even with cell(s) of a third kind.

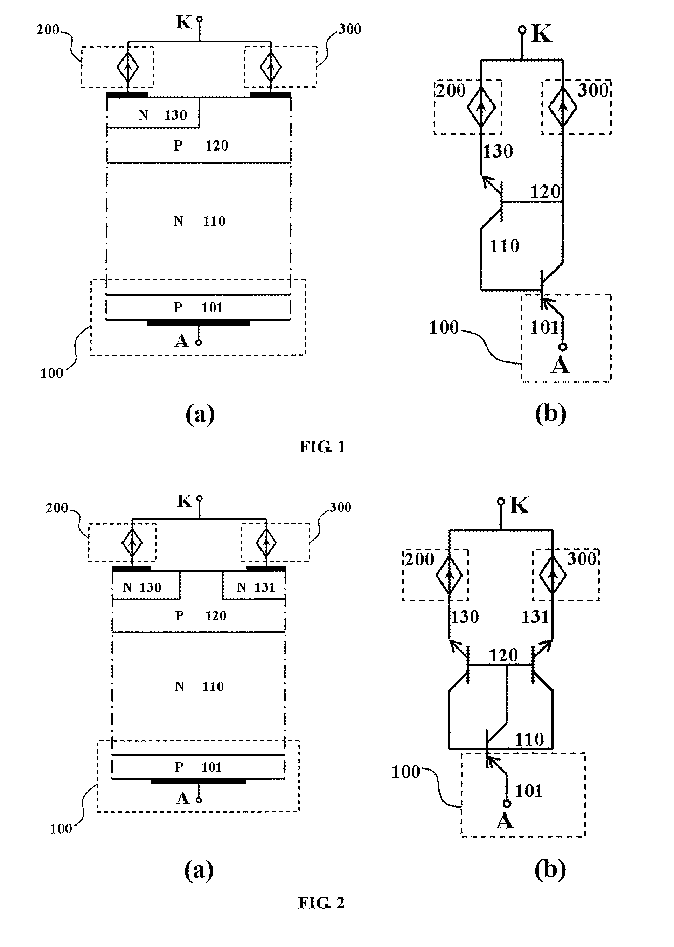

The cell of the first kind (the structure of the device shown in Fig. 1, Fig. 2, Fig. 3, Fig. 4, Fig. 5, Fig. 6, Fig. 7, Fig. 8, Fig. 9, Fig. 10, Fig. 11 and Fig. 12) comprises:

a first n-region (n-region 110 or n-regions 110 and 103 in each figure) is the main voltage-sustaining region, wherein the entire region or most of the region is lightly doped;
one surface of the said first n-region is contacted with a first p-region with heavily doped (region 101 in each figure);
another surface of the first n-region is contacted with one surface of a second p-region (region 120 in each figure);
at least a part of the other surface of the said second p-region is contacted with a second n-region (region 130 in each figure);
the said second n-region (region 130 in each figure) is connected with a first terminal of a first controlled current source (200 in each figure), another part of the said second p-region (region 120 in each figure) is connected with a first terminal of a second control current source (300 in each figure) and both second terminals of the first and the second controlled current source are connected with a first conductor, which is a first electrode (K in each figure) of the two controlled electrodes;

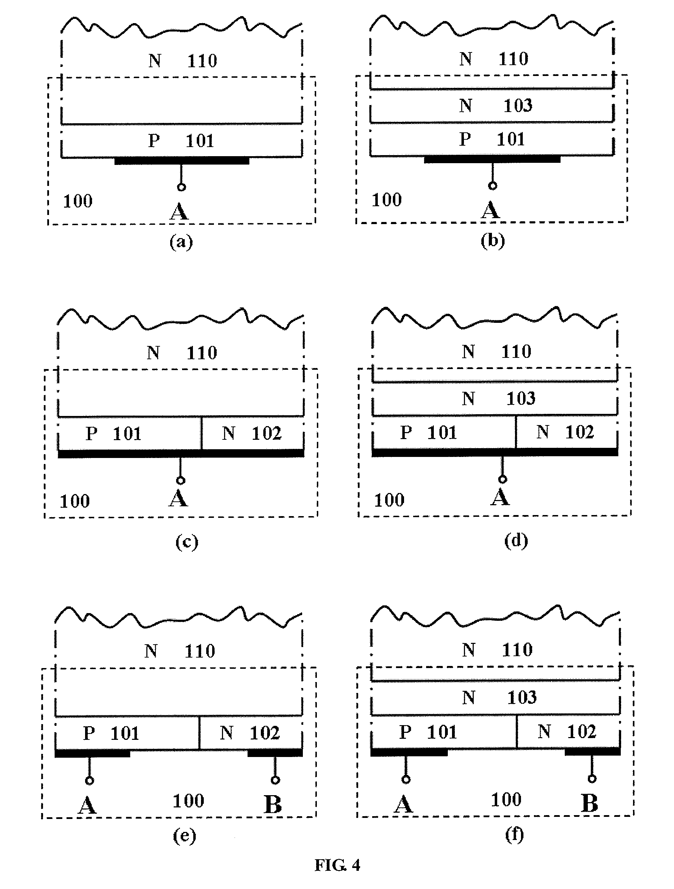

the said second main surface has either of two connection methods: a first one is that only a second conductor (the bold black line connected with 101 in each figure) is connected with the first p-region (region 101 in each figure), and the conductor is a second electrode (A in each figure) of the two controlled electrodes; a second one is that besides the second conductor, there is a third conductor, which is base (B in Fig. 4), connected with the first lightly doped n-region (n-region 110 in each figure) through an n-region (shown in Fig. 4(e) or in Fig. 4(f));

said first controlled current source controls the electron current flowing through the first n-region (n-region 110 in each figure), said second controlled current source controls the hole current flowing through the first n-region (n-region 110 in each figure); the current between two controlled electrodes (electrodes A and K) is controlled by the two current source controlling the currents of two types of carriers;

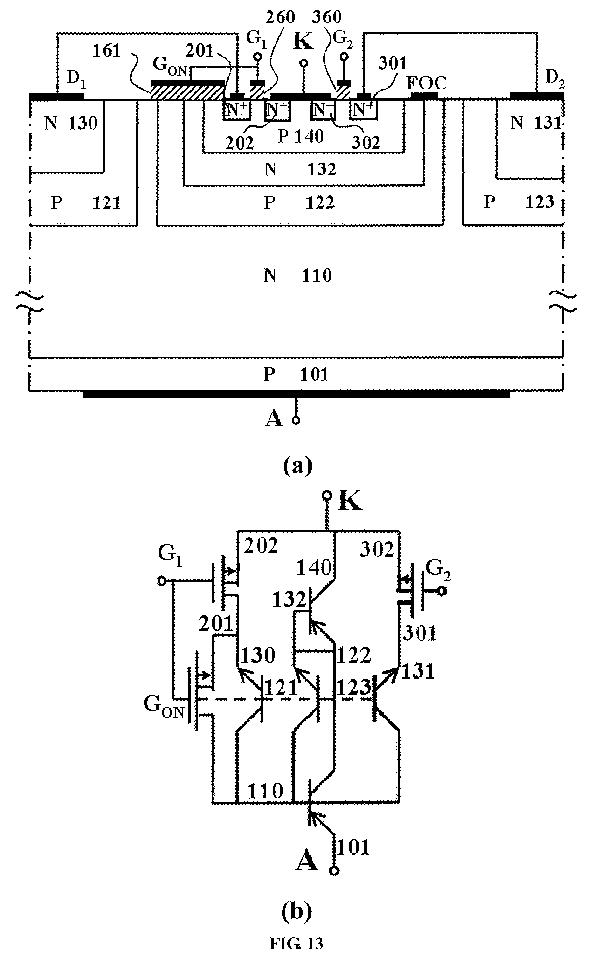

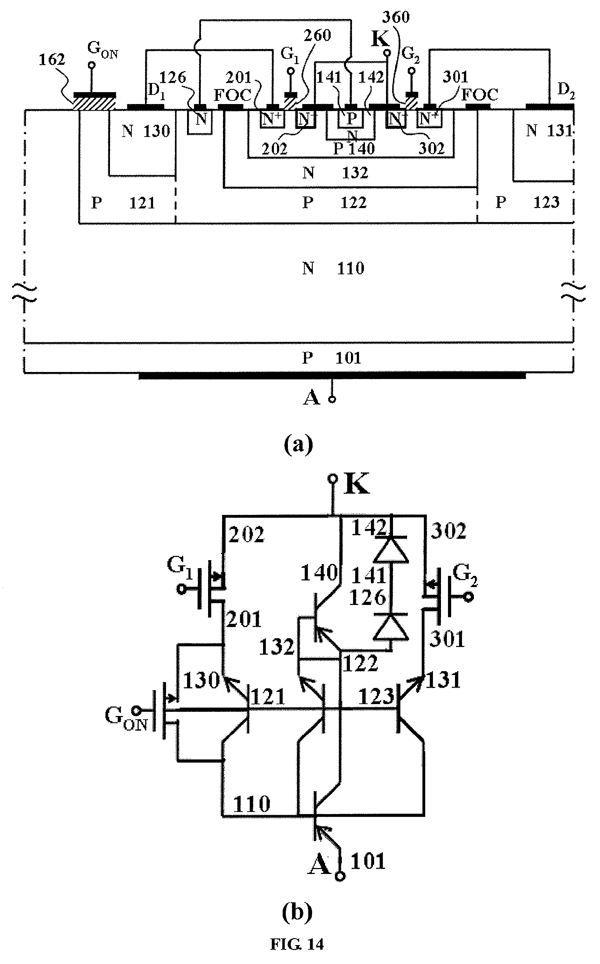

The cell of the second kind has not only the features of the cell of the first kind, but also has features wherein a portion of the first N-type region ( N-type region 110 in Fig. 13, Fig. 14, Fig. 15, Fig. 16, and Fig. 17) is contacted directly to a portion of the first main surface; a first insulator layer (161 in Fig. 13 and 162 in Figs. 14~17) covers on this region, the second p-region (122 in Fig. 13 and 121 in Figs. 14~17) and the second n-region (132 in Fig. 13 and 130 in Figs. 14~17) on the first main surface; the first insulator layer is covered by a conductor ($G_{on}$ in Figs. 13~17); the first n-region contacted (110 in Figs. 13~17) with the first main surface and the second n-region (132 in Fig. 13 and 130 in Figs. 14~17) are drain region and source region of a n-MIS, respectively; the second p-region (122 in Fig. 13 and 121 in Figs. 14~17) severs as a source substrate region and the conductor covered on the insulator layer as gate of the n-MIS; the signal applied to the gate can control the current between the drain region and the source region of the n-MIS;

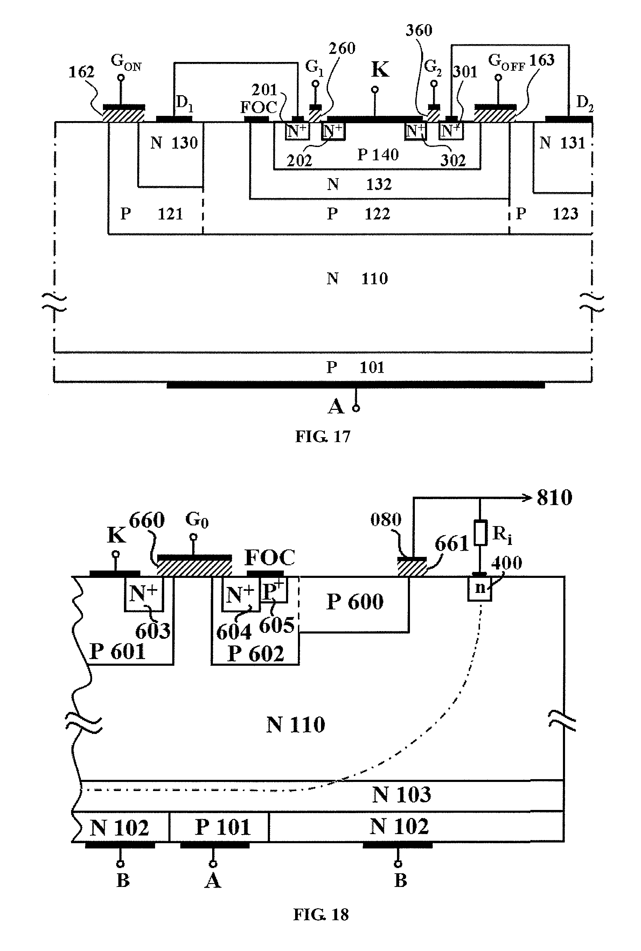

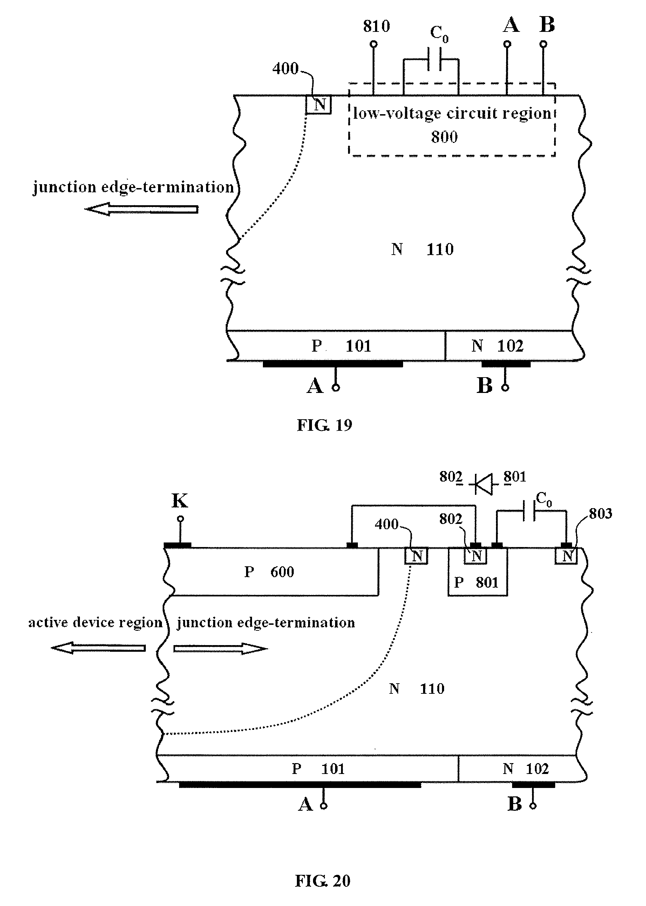

The cell of the third kind has not only the features of the cell of the first kind, but also has features wherein (refer to Ref. [1]), a second insulator layer (660 in Fig. 18) covers on a part of the second p-region (601 in Fig. 18) and a part of a p-region (602 in Fig. 18), which locates outside the boundary of the operation region and severs as junction terminal region; said junction terminal region at the first main surface starts at a first side, which is the boundary of the operation region, and ends at a second side, which locates at a region in the first n-region without electric field even under large high voltage drop across the two controlled electrodes (electrodes A and K); a conductor covers on the second insulator layer (660 in Fig. 18) and severs as a turning-off gate ($G_0$ in Fig. 18); a low-voltage circuit is implemented outside the second side of the junction terminal region; the low-voltage circuit has two output terminals (A and B of region 800 in Fig. 19): a first one is connected with the second electrode (electrode A) and a second one is connected with the base (electrode B in Fig. 19) in the second connection method;

the low-voltage circuit has two input terminals, wherein, a first input terminal either can be region 400 in Fig. 19 or connected to the region in the first n-region without electric field even under large high voltage drop across the two controlled electrodes; a second input terminal, which is connected with a part of junction terminal region close to the second side, is the controlling terminal (810 in Fig. 19) of the low-voltage circuit;

when a pulse signal is applied to the turning-off gate ($G_0$ in Fig. 18), the current between the two output terminals (A and B of region 800 in Fig. 19) can be very large while the voltage drop across them is very low, which stops the hole injection into the first n-region (n-region 110) from the first p-region (101).

2. Referring to Fig. 4(c) and Fig. 4(d), the third conductor (the base, electrode B according to 1) is connected directly to the second electrode (electrode A), not connected to the second output terminal of the low-voltage circuit.

3. The current sources can be two external current sources , which are connected with the first terminal of the first controlled current source (200 in each figure) and the first terminal of the second controlled current source (300 in each figure), respectively.

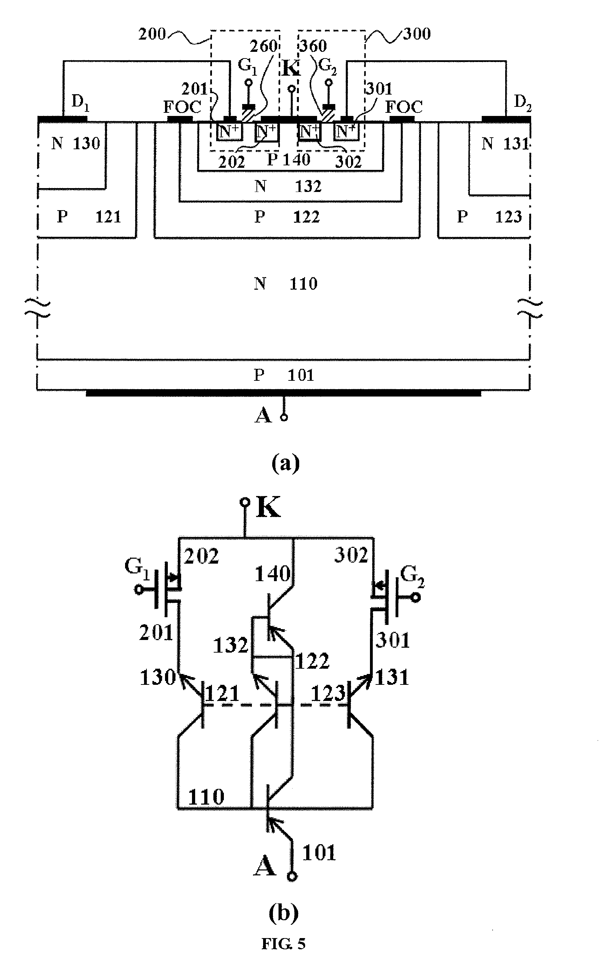

The present invention also provides the methods of the two current sources being implemented in the device. Referring to Fig. 5 and Fig. 13, wherein the second p-region according to 1 can be divided into three sub-regions, isolated by the first n-region (110) from each other; each sub-region has its own second n-region (130, 131, 132), which is surrounded respectively by a second p-region (121, 123,122) and the first main surface; the dose of the second n-region (130) in a first sub-region (121) is much larger than that of the first sub-region; the dose of the second n-region (131) in a second sub-region is much smaller than that of the second sub-region (123); the second n-region (132) in a third sub-region (122) is connected with the third sub-region by using floating ohmic contact (FOC) on the first main surface; a third p-region (140) is implemented in the second n-region of the third sub-region and contains at least two n-MISs; the source regions (202 and 302) of the two n-MISs are connected with the third p-region (140), which severs as the source substrate region, at the first main surface through the conductor, which is the first electrode (electrode K) of the two controlled electrodes; the drain regions (201 and 301) of the two n-MISs are connected with the second n-regions (130 and 131) of the first sub-region and the second sub-region, respectively; there are at least two insulator layers (260 and 360) on the first main surface, which cover on a part of drain regions (201 and 301), a part of source regions (202 and 302) and the source substrates region (140) between them, respectively; the two insulator layers are covered by conductors severing as the gates ($G_1$ and $G_2$) of the two n-MISs, which control the currents of the two n-MISs, respectively.

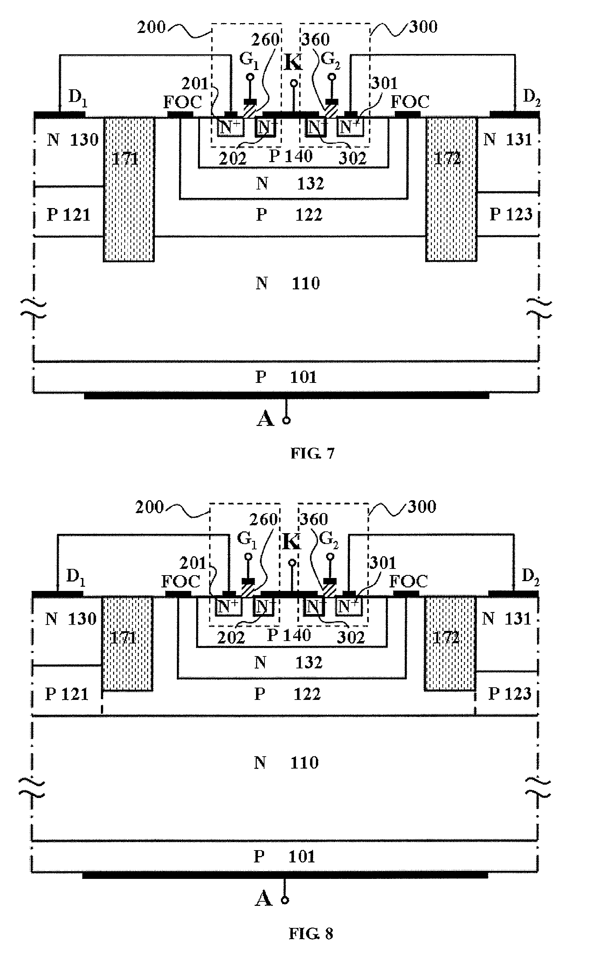

4. Referring to Fig. 7, the second P-type region can also be divided by trenches filled with insulators.

The second P-type region up to the first main surface is divided into three sub-regions isolated one to another by trenches filled with insulators (171 and 172); each sub-region has its own second N-type region (130, 131 and 132); wherein in the first sub-region, the dose of doping of the second N-type region (130) is much larger than a dose of doping of the second P-type region (121), in the second sub-region, the dose of doping of the second N-type region (131) is much smaller than a dose of doping of the second P-type region (123); wherein the second P-type region (122) in third sub-region is connected with its own second N-type region (132) by using floating ohmic contact (FOC) on the first main surface; a third P-type region (140) is surrounded by its own second N-type region (132) and the first main surface, the third P-type region (140) contains at least two n-MIS's; two source regions (202 and 302) of the two n-MIS's are connected through the first conductor (electrode K) to the third P-type region (140) serving as a source-body region of both two n-MIS's; two drain regions (201 and 301) of the two n-MIS's are connected with the second N-type regions (130 and 131) of the first sub-region and of the second sub-region, respectively; at least two insulator layers (260 and 360) are formed on the first main surface, each of them covers on a part of each drain region (201 and 301), a part of each source region (202 and 302) and source-body region (140) of each n-MIS, respectively; the two insulator layers are covered by two conductors serving as two gates ($G_1$ and $G_2$) of the two n-MIS's, controlling two currents of the two n-MIS's, respectively.

5. Also, Referring to Fig. 8, the second P-type region can be partly divided by trenches filled with insulators.

the second p-region according to 1 can be locally divided by trench insulators, wherein local part of them are connected with each other (122 is connected with 121 and 123) and other part are isolated by the trench insulators (171 and 172) from each other; each sub-region has its own second N-type region (130, 131 and 132); wherein in the first sub-region, the dose of doping of the second N-type region (130) is much larger than the dose of doping of the second P-type region (121) surrounding it, in the second sub-region, the dose of doping of the second N-type region (131) is much smaller than the dose of doping of the second P-type region (123) surrounding it; wherein the second P-type region (122) in third sub-region is connected with its own second N-type region (132) by using floating ohmic contact (FOC) on the first main surface; a third p-region (140) is implemented in the second n-region of the third sub-region and contains at least two n-MISs, the source regions (202 and 302) of the two n-MISs are connected with the third p-region (140), which severs as the source substrate region, at the first main surface through the conductor, which is the first electrode (electrode K) of the two controlled electrodes; two drain regions (201 and 301) of the two n-MIS's are connected with the second N-type regions (130 and 131) of the first sub-region and of the second sub-region, respectively; at least two insulator layers (260 and 360) are formed on the first main surface, each of them covers on a part of each drain region (201 and 301), a part of each source region (202 and 302) and source-body region (140) of each n-MIS, respectively; the two insulator layers are covered by two conductors serving as two gates ($G_1$ and $G_2$) of the two n-MIS's, controlling two currents of the two n-MIS's, respectively.

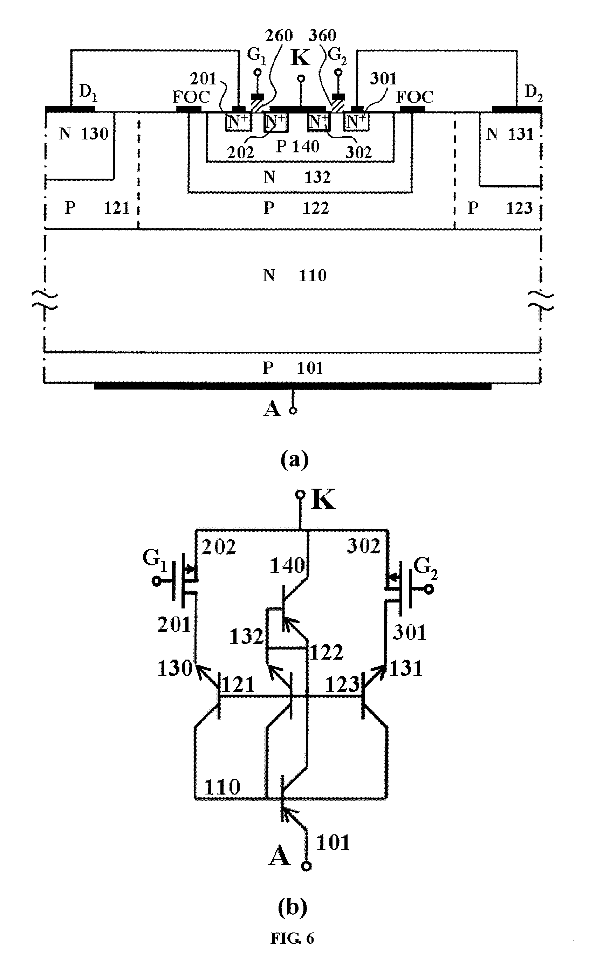

6. Referring to Fig. 6, the three sub-regions of the second P-type region can be connected together.

According to 1, the second P-type region up to the first main surface is divided into three sub-regions (121, 123 and 122) connected each other; each sub-region has its own second N-type region (130, 131 and 132) surrounded individually by each P-type sub-region and the first main surface, wherein: in the first sub-region, the dose of doping of the second N-type region (130) is much larger than the dose of doping of the second P-type region (121) surrounding it; in the second sub-region, the dose of doping of the second N-type region (131) is much smaller than the dose of doping of the second P-type region (123) surrounding it; wherein the second P-type region (122) in third sub-region is connected with its own second N-type region (132) by using floating ohmic contact (FOC) on the first main surface; a third P-type region (140) is surrounded by its own second N-type region (132), the third P-type region (140) contains at least two n-MIS's; two source regions (202 and 302) of the two n-MIS's are connected through the first conductor (electrode K) to the third P-type region (140) serving as a source-body region of both two n-MIS's; two drain regions (201 and 301) of the two n-MIS's are connected with the second N-type regions (130 and 131) of the first sub-region and of the second sub-region, respectively; at least two insulator layers (260 and 360) are formed on the first main surface, each of them covers on a part of each drain region (201 and 301), a part of each source region (202 and 302) and source-body region (140) of each n-MIS, respectively; the two insulator layers are covered by two conductors serving as two gates ($G_1$ and $G_2$) of the two n-MIS's, controlling two currents of the two n-MIS's, respectively.

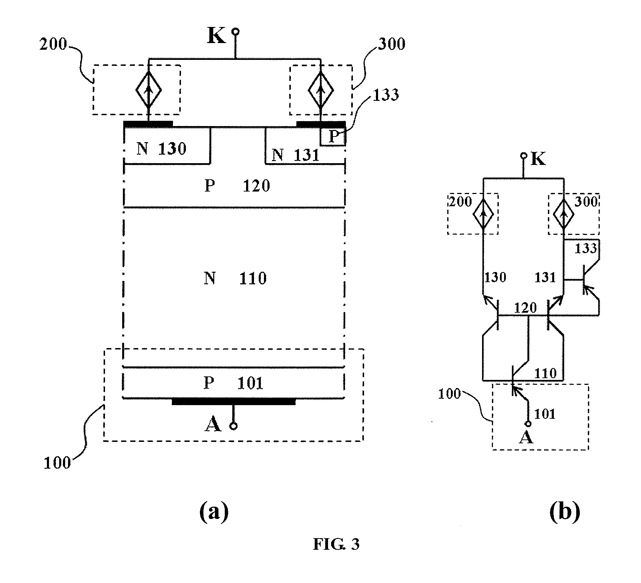

7. Referring to Fig. 3, wherein the second n-region (131) in the second sub-region of the second p-region is connected with an additional p-region (133) in it through a conductor and the p-region is not connected with the second p-region.

According to 3-6, wherein the second N-type region (131) in the second sub-region is connected with a P-type region (133) which is not connected with the second P-type region through a conductor.

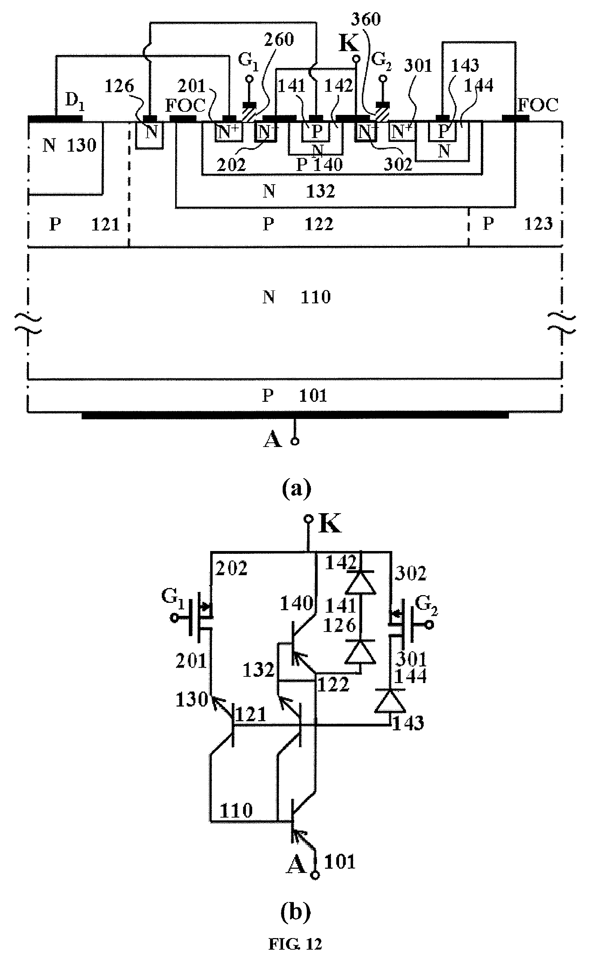

8. Referring to Fig. 12, the current source in the second P-type region can be set in the third sub-region. The semiconductor device according to 1, wherein: an N-type region (132) surrounded by the second P-type region (123 and 122) and the first main surface, and both regions are connected through FOC on the first main surface; a third P-type region (140) is surrounded by the said N-type region (132) and the first main surface; at least two n-MIS's are implemented in the third P-type region (140); the source regions (202 and 302) of the two n-MISs are connected with the third p-region serving as a source-body region of both two n-MIS's through a conductor on the first main surface and the conductor is the first one (electrode K) of the two controlled electrodes; the drain region (144) of one n-MISs contains a p-region (143) surrounded by the drain region and the first main surface; the p-region is connected with the second p-region (123); there are at least two insulator layers (260 and 360) on the first main surface, which cover on a part of drain regions (201 and 301), a part of source regions (202 and 302) and the source substrates region (140) between them, respectively; the two insulator layers are covered by conductors severing as the gates ($G_1$ and $G_2$) of the two n-MISs, which control the currents of the two n-MISs, respectively.

9. The current sources can also be located in SIS (Silicon Insulator Silicon)

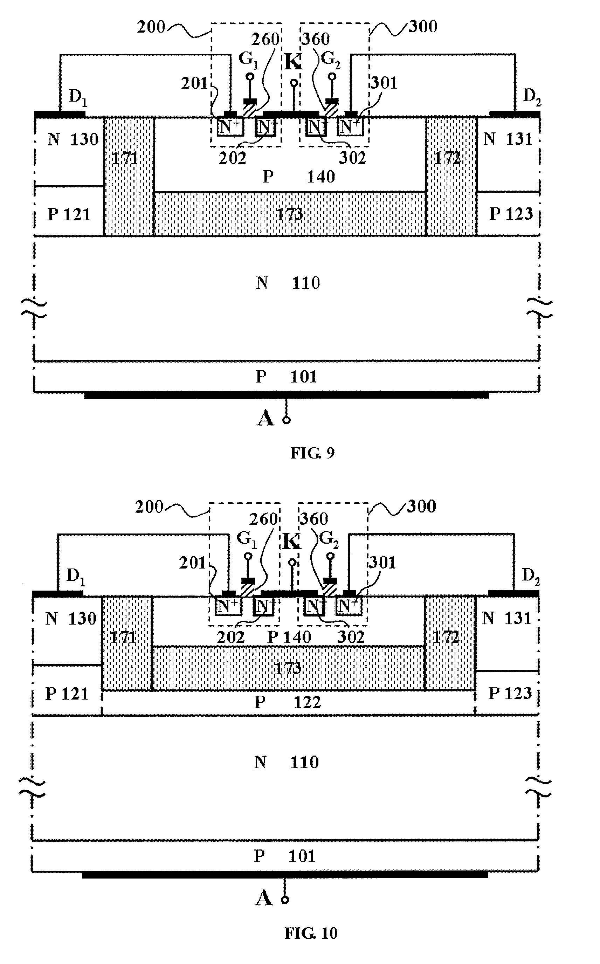

Referring to Fig. 9 and Fig. 10, the two current sources according to 1 are implemented in a third P-type region (140) which is isolated with other regions having no current source by insulators (171, 172 and 173).

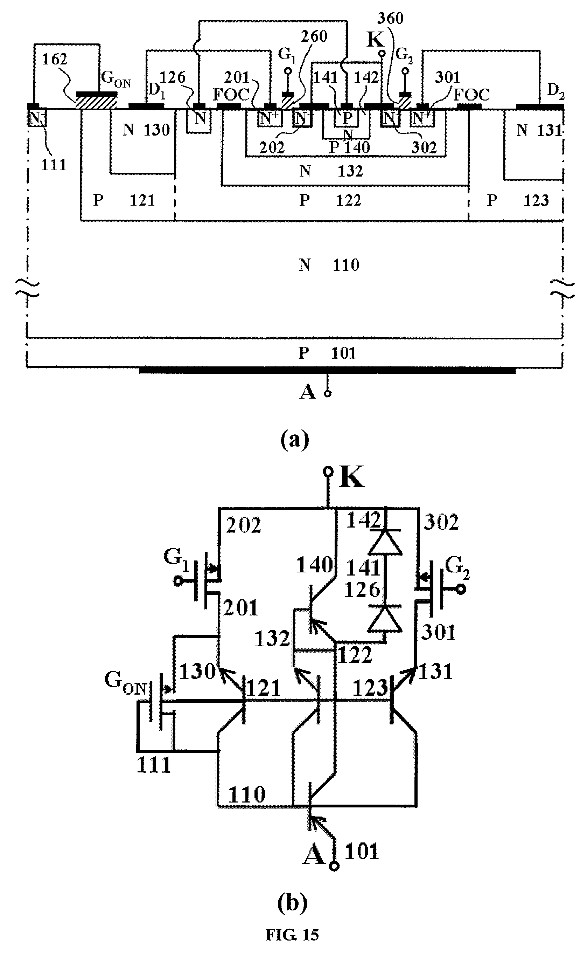

10. Referring to Fig. 15, a method to generate automatically a voltage applied to $G_{on}$ is proposed in the present invention.

According to 1, wherein the gate of the n-MIS ($G_{on}$) in the cell of second kind is connected with a heavily doped n-region (111) in the first n-region (110) in the first main surface.

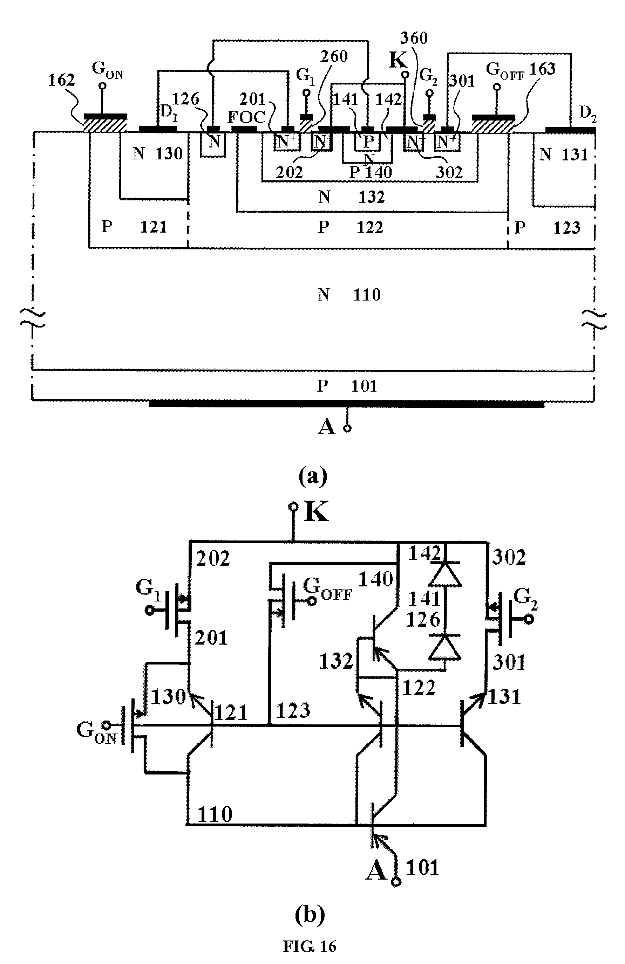

11. Referring to Fig. 16 and Fig. 17, a method to make two current sources stop applying current to both of the second n-region and the second p-region even though the controlled voltages are applied to the controlled electrodes of the two current sources are proposed in the present invention, which is realized by adding a gate $G_{off}$. In this method, the clamped diodes are not necessary.

According to 3, 4, 5, 6, 9 and 10, wherein: the second P-type sub-region (123) serves as a source region, the second N-type region (132) serves as a substrate region and the third P-type region (140) serves as a drain region of the p-MIS, respectively; an insulator (163) covers on the first main surface starting from a part of the source region, via the substrate region and ending at a part of drain region of the p-MIS; the insulator is covered by a conductor serving as a gate ($G_{off}$) of the p-MIS. When a voltage is applied on the gate ($G_{off}$) to turn on the p-MIS, the voltage drop between the second P-type region and the first electrode (electrode K) is very small (the voltage is smaller than 0.7V for silicon devices). Not to mention that another method to get such a small voltage drop is to form an n-MIS between the second N-type region (132) of the third sub-region and the third P-type region (140).

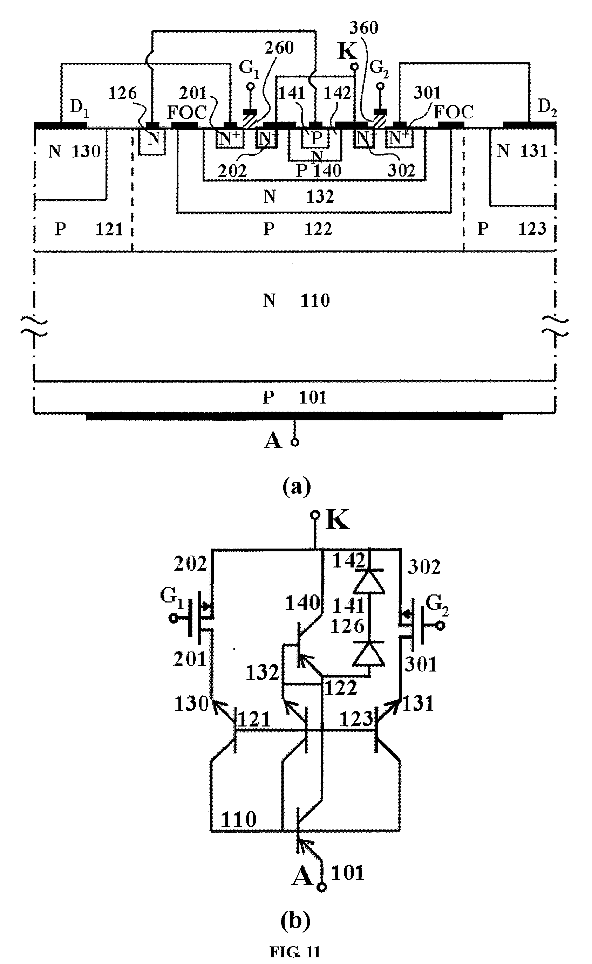

12. Referring to Fig. 11, Fig. 12, Fig. 14, Fig. 15 and Fig. 16, a method to clamp the voltage drop across the two terminals of the current source is proposed in order to prevent large voltage drop across the two terminals of the current source.

According to 4 or 5, or 6 or 8, or 9 or 11, at least two series clamping diodes are implemented between the second P-type region (122) and the third P-type region (140). The first diode is formed by forming an N-type region (126) in the second P-type region (122); the second diode is formed by forming a p-type region (141) in the N-type region (142) which is surrounded by the third P-type region (140).The N-type region (142) of the second diode is connected with the third P-type region (140) through a conductor (conductor of electrode K) on the first main surface. The N-type region of the first diode is connected with the P-type region of the second diode through a conductor.

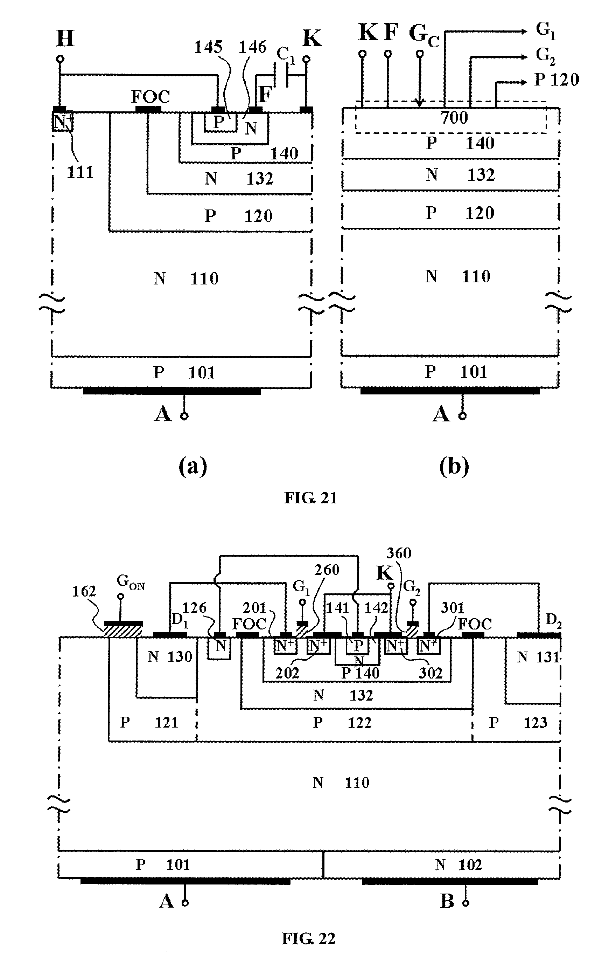

13. Referring to Fig. 21, a method to provide a power supply, which has a low-voltage with respect to the first electrode (K in each figure), is proposed in the present invention by implementing a heavily doped n-region in the first n-region in the first main surface. Such power supply is applied to input terminals of the two current sources described in 3.

According to 1, wherein: a heavily doped n-region (111) is implemented in the first main region in the cell of the first kind and contacted directly with the first n-region (110); the heavily doped n-region is contacted directly with a conductor (H); a second n-region (132) is implemented in the second p-region (120) and connected with the second p-region (120) by FOC on the first main surface; a third p-region (140) is implemented in the second n-region (132), a third n-region (146) is implemented in the third p-region (140) and a fourth p-region (145) is implemented in the third n-region (146); the fourth p-region (145) is contacted directly with a conductor, which is connected with the conductor (H) which is contacted with the heavily doped n-region (111); the third n-region (146) is contacted with a conductor (F) on the first main surface, which is connected with a terminal of a capacitor (C1); the other terminal of the capacitor is connected with the first controlled electrode (K); the capacitor severs as a power supply of a low-voltage circuit implemented in the third p-region (140); the input terminal ($G_C$) of the low-voltage circuit is external and the output terminals sever as the control voltages of the two current sources or the second p-region (120).

14. Referring to Fig. 20, a method to apply a power supply with respect to the second controlled electrode (A) for a low-voltage circuit is proposed.

According to 1, wherein: a conductor is contacted in a portion of the junction edge termination region close to its second side on the first main surface; the conductor is connected to another conductor on the first main surface contacted with an N-type region (802) surrounded by a P-type region (801) and located outside of the second side of the junction edge termination region; the P-type region (801) is contacted directly with a conductor on the first main surface, and is connected with one terminal of a capacitor ($C_0$); the other terminal of the said capacitor is connected with the first N-type region (110) located outside the second side of the junction edge termination region; said capacitor is used as the power supply for the low-voltage circuit implemented outside the second side of the junction edge termination region.

## BRIEF DESCRIPTION OF THE DRAWINGS

Fig. 1(a) schematically shows one structure for illustrating the principle of the present invention;
Fig. 1(b) shows the simple equivalent circuit of Fig. 1(a);
Fig. 2(a) schematically shows another structure for illustrating the principle of the present invention;
Fig. 2(b) shows the simple equivalent circuit of Fig. 2(a);
Fig. 3(a) schematically shows still another structure for illustrating the principle of the present invention;
Fig. 3(b) shows the simple equivalent circuit of Fig. 3(a);
Fig. 4 shows schematically several kinds of structures beneath the voltage-sustaining region;
Fig. 5(a) shows schematically a structure with current sources implemented in the chip;
Fig. 5(b) shows the simple equivalent circuit of Fig. 5(a);
Fig. 6(a) shows schematically another structure with current sources implemented in the chip;
Fig. 6(b) shows the simple equivalent circuit of Fig. 6(a);
Fig. 7 shows schematically a structure based on Fig. 5(a) or Fig. 6(a) by using dielectric isolation;
Fig. 8 shows schematically another structure based on Fig. 5(a) or Fig. 6(a) by using dielectric isolation;
Fig. 9 shows schematically a structure based on Fig. 5(a) or Fig. 6(a) by using the technique of SIS;
Fig. 10 shows schematically another structure based on Fig. 5(a) or Fig. 6(a) by using the technique of SIS;
Fig. 11(a) shows schematically a structure with additional clamping diodes;
Fig. 11(b) shows the simple equivalent circuit of Fig. 11(a);
Fig. 12(a) shows schematically another structure to implement the current source for providing hole current in Fig. 1(a) and Fig. 2(a);
Fig. 12(b) shows the simple equivalent circuit of Fig. 12(a);
Fig. 13(a) shows schematically a structure adding a turn-on gate to increase the turn-on speed;
Fig. 13(b) shows the simple equivalent circuit of Fig. 13(a);
Fig. 14(a) shows schematically another structure with a turn-on gate to increase the turn-on speed;
Fig. 14(b) shows the simple equivalent circuit of Fig. 14(a);
Fig. 15(a) shows schematically a structure which can achieve fast turn-on by automatically providing the signal of turn-on gate;
Fig. 15(b) shows the simple equivalent circuit of Fig. 15(a);
Fig. 16(a) shows schematically a structure with an additional turn-off gate based on the structure shown in Fig. 14(a);
Fig. 16(b) shows the simple equivalent circuit of Fig. 16(a);
Fig. 17 shows schematically a structure without the clamping diodes based on the structure shown in Fig. 16(a);
Fig. 18 shows schematically the method to produce a control signal for the low-voltage circuit, according to the Fig. 21 of Ref. [1];
Fig. 19 shows schematically a diagram of the low-voltage circuit to realize anode-short;
Fig. 20 shows schematically a method to implement the power supply of the low-voltage circuit;
Fig. 21 (a) shows schematically a method to obtain a positive power supply with respect to the cathode by the device itself;
Fig. 21 (b) shows schematically the diagram of the control circuit;
Fig. 22 shows a schematic diagram of Fig. 14 by using the structure in Fig. 4(e);
Fig. 23 shows the DC characteristic of the cell structure in Fig. 22, simulated by using TMA-MEDICI package;
Fig. 24 shows the switching characteristic of the cell structure in Fig. 22, simulated by using TMA-MEDICI package;
Fig. 25(a) shows schematically a cell of hexagonal structure;
Fig. 25(b) shows schematically the close-packed structure of the cells shown in Fig. 25(a).

## DESCRIPTION OF THE PREFERRED EMBODIMENTS

The present invention will be described and illustrated in detail, and the examples of the application of the present invention will be demonstrated hereinafter. In all of the following figures, the same number represents the same component or element.

All of the conductors in the following figures are indicated by bold lines hereinafter.

The basic structure and simple equivalent circuit of the active region of the thyristor proposed in the present invention are shown in Fig. 1.

Fig. 1(a) shows the basic structure of the active region proposed in the present invention. An anode A located at the bottom of this figure is connected to a first P-type region 101 through a conductor to inject holes into a first lightly doped N-type region 110, which serves as the voltage-sustaining region. There is a second P-region 120 upon the voltage-sustaining region. The upper right portion of the second P-region 120 is connected in series to a current source 300 through a conductor and then connected to a cathode K. Thus, when the external voltage $V_{AK}$ is higher than zero, P-region 101, N-region 110 and P-region 120 construct the emitter region, base region, and collector region of the first transistor (PNP), respectively.

There is an N-region 130 upon the left part of the second P-region 120, which is connected to a current source 200 through a conductor and then connected to the cathode K. When the voltage $V_{AK}$ is higher than zero, the electrons are emitted from the N-region 130 to the P-region 120 and extracted by the N-region 110. Thus, N-region 130, P-region 120, and N-region 110 construct the emitter region, the base region, and the collector region of the second transistor (NPN), respectively.

Fig. 1(b) shows the equivalent circuit composed of two transistors and two current sources.

The most important difference between the structure shown in Fig. 1(a) and the devices of GTO and MCT lies in the two current sources.

The purpose of setting two current sources is to make sure the carrier densities in the voltage-sustaining region with the current flowing satisfy the following condition:

$$n\text{-}p\text{-}N_D^+ \approx 0 \qquad\qquad (1)$$

where $n$, $p$ and $N_D^+$ are the densities of electrons, holes and the effective ionized donors in the N-region 110. When the current is large enough, both $n$ and $p$ are much higher than $N_D^+$. If $n \gg p$, the voltage-sustaining region is equivalent to a heavily doped P-region, and thus can not sustain a very high voltage. If $p \gg n$, the voltage-sustaining region is equivalent to a heavily doped N-region, and also can not sustain a very high voltage. Obviously, in both cases, a saturation of current at a high voltage can not be realized.

Note that for Si, when the electric field is higher than $2\times10^4$V/cm, the velocities of electron and hole are approximately equal to their saturation values, $v_{Se}$ and $v_{Sh}$, respectively. On the other hand, when the electric field is higher than $2\times10^5$V/cm, the impact ionization rate will be significant. Hence, to satisfy the condition of (1), it is only required that the ratio of current density of electron to the one of hole satisfies: $(J_e/J_h) = (v_{Se}/v_{Sh})$. Since for Si, $(v_{Se}/v_{Sh}) \approx 1$, the requirement of (1) is that the electron current density equals to the hole current density.

According to the method of Fig. 1, in order to maintain the P-N junction composed of the P-region 120 and the N-region 130 forward biased for injection, the potential of the P-region 120 connected with 300 should be higher than that of the N-region 130 connected with 200. This higher value is about 0.7V for Si, which obviously causes more power dissipation per unit area. Therefore, a separation of the top N-region into a heavily doped region 130 and a lightly doped region 131 shown in Fig. 2(a) is made. Meanwhile, the dose of doping in the portion of the P-region 120 surrounding the N-region 130 is made to be very low, and the portion of the P-region 120 surrounding the N-region 131 is made to be very high. Thus, the N-region 130 and the P-region 120 form an N+-P- junction and the main current flows through this junction is an electron current; the N-region 131 and the P-region 120 form an N-P+ junction and the main current flows through this junction is a hole current.

Fig. 2(b) shows the simple equivalent circuit of Fig. 2(a).

The conductor connecting 300 and the N-region 131 in Fig. 2(a) can also be contacted simultaneously with a P-region 133, as shown in Fig. 3(a). The PNP composed of the P-region 120, N-region 131 and P-region 133 is a transistor with collector shorted. The equivalent circuit is shown in Fig. 3(b).

There are several structures of region 100 beneath the voltage-sustaining region 110 of Fig. 1 (a), as shown in Fig. 4. In Fig. 4(a), the voltage-sustaining region 110 is directly connected with a P-region 101 which is connected with the electrode A. The difference between Fig. 4(b) and Fig. 4(a) lies in the addition of an N-buffer layer 103. This region has a heavier doping concentration than the N-region 110 and a small thickness. A structure of anode shorted is shown in Fig. 4(c), wherein the electrode A is connected with the P-region 101 and the voltage-sustaining region 110 through an N-region 102. Sometimes, in order to achieve a better effect of anode shorted, an N-region 103 beneath the N-region 110 with a heavier doping concentration than the N-region 110 is needed, as shown in Fig. 4(d). In the structure shown in Fig. 4(e), the N-voltage-sustaining region 110, the base region, is connected to the outer through the N-region 102. Fig. 4(f) shows the structure based on Fig. 4(e), wherein the N-region 103 with a heavier doping concentration is set on the P-region 101 as well as on the N-region102 to achieve a better effect of an anode-short. Both of the structures shown in Fig. 4(e) and Fig. 4(f) are used for fast turn-off and the specific application of them will be described later. In the following figures, the connection method is shown as Fig. 4(a), which, of course, can be replaced by any method shown in Fig. 4(b), Fig. 4(c), Fig. 4(d), Fig. 4(e) or Fig. 4(f). When the n-voltage-sustaining region 110 is used as base region by being connected to the outer through an n-region 102 , the method shown in Fig. 4(e) is utilized in the following figures, Fig. 4(f) can also be used.

The current sources 200 and 300 in the Fig. 2(a) can be externally connected to the chip, but also can be integrated in the same chip with the thyristor. Fig. 5(a) shows a cell with the current sources implemented inside the chip. Here, the P-region 120 is divided into three individual P-regions: 121, 122, and 123. The N-region 130 is set in the P-region 121 and the N-region 131 is set in the P-region 123. The current sources are set in a P-region 140 which is surrounded by an N-region 132, which is connected with the P-region 122 by floating ohmic contacts (FOC) on the first main surface (the top surface). As the source substrate region for two n-MIS's, the P-region 140 is connected with the source regions 202 and 302 of two n-MIS's at surface through a conductor. The drain regions of the two n-MIS's are $N^+$-regions 201 and 301, which are connected through conductors to an electrode $D_1$ on the N-region 130 and $D_2$ on the N-region 131, respectively. There are two insulators 260 and 360 covering on the source substrate region from a part of the source region to a part of the drain region of the two n-MIS's, respectively. The conductors covering on the insulators are the gates G1 and G2 of the two n-MISs, respectively. The currents of the two n-MIS's are controlled by the external voltages of $G_1$ and $G_2$, thereby the currents flowing through 130 and 131 can be controlled. In practice, the dose of doping concentration of the P-region 121 can be much smaller than that of the N-region 130 which is surrounded by 121. As a result, the current flowing through 130 is a current with electrons flow downward dominantly. On the contrary, the dose of doping concentration of the P-region 123 is much larger than that of the N-region 131 which is surrounded by 123. As a result, the current flowing through 130 is dominantly a hole current with hole flows upward. Since both of the forward voltages making the P-N junctions composed of 130 and 121 and the junction composed of 123 and 131 turning on are about 0.7V (for Si), When the two n-MISs are implemented completely the same, if the currents flowing through those n-MIS are not equal, the voltage drop across those n-MISs would not be equal and the side with larger current has higher voltage drop, resulting the voltage drop across the P-N junction on this side decrease. By using the principle of such negative feedback, the requirement that electron current should be equal or approximately equal to hole current is easily realized.

Fig. 5(b) shows the simple equivalent circuit of Fig. 5(a).

For the purpose of implementing the two current sources 200 and 300 as shown in Fig. 2, it is not necessary to divide the P-region 120 in this figure into three individual sections, but can connect these sections together, as shown in Fig. 6(a). Here, the number of each region is the same with that of Fig. 5. The function of it is not to be repeated. Note that the dose of doping concentration of the P-region 122 can be heavy to reduce its lateral resistance. Thus, the potential of the two sides (P-region 121 and P-region 123) will not be unequal produced by a lateral current.

Fig. 6(b) shows the simple equivalent circuit of Fig. 6(a).

Also, n-region 130 and/or n-region 131 in Fig. 5(a) or Fig. 6(a) can be not entirely surrounded by p-region 121 and/or 123, which is realized by using the technique of trench. Fig. 7 schematically shows isolating those three p-regions in Fig. 5(a) or Fig. 6(a) completely by using dielectrics 171 and 172. Fig. 8 schematically shows isolating those three p-regions in Fig. 5(a) or Fig. 6(a) partially by using dielectrics. In these two figures, only the bottoms of n-region 130 and n-region 131 are contacted to p-region and their edges have no p-region surrounding.

The two n-MIS's are used to work as two current sources in Fig. 5(a) or Fig. 6(a) due to that n-MIS needs lower drain-source voltage with the same conduction current, thus conduction loss can be reduced. However, in order to implement the n-MIS, a P-type source substrate region 140 is required, and this P-region can not be replaced by the P-region 122, otherwise holes injected from the P-region 101 will directly flow into the electrode K through the P-region 122 and the capability of controlling two  carriers would be lost. As a consequence, an N-region 132 whose potential is equal to that of the P-region 122 is added. If the current source is implemented in a semiconductor region which is insulated from other semiconductor regions, the N-region 132 does not necessarily being used. Fig. 9 shows a method to isolate the current source region by using insulators 171 and 172 (e. g. using the technique of Trench) at two sides and an insulator 173 (e. g. using the technique of SIS) at the bottom and then the P-region 140 serves as the source substrate region.

Naturally, this method has certain flexibility. For example, a part of the P-region 122 can be remained beneath the insulator region, as shown in Fig. 10. Thus, the path of holes, which have flowed through the voltage-sustaining region 110 into the upper layer, can be widened. At the same time, the potentials of the P-regions 121 and 123 are closer, making the electron current density and the hole current density to be closer.

Fig. 11(a) shows a P-N diode composed of the P-region 122 and an N-region 126 which is connected to a P-region 141 through inner connection or outer connection, and the P-region 141 is set in an N-region 142, forming another diode. The N-region 142 is connected with the P-region 140 and the cathode K through a conductor. That is to say, there are two diodes from the P-region 122 to the cathode K. Therefore, although the current flowing from the P-region 122 to K is very large, the voltage across these regions will not exceed the sum of the forward voltage of these two diodes ($\approx$1.5V for Si devices), which can avoid the drain-source voltage of those two n-MISs controlled by $G_1$ and $G_2$ to be too high under large current, in other words, these two diodes play a role of clamping, and this structure is not to be repeated hereinafter.

Fig. 11(b) shows the simple equivalent circuit of Fig. 11(a).

There is another implementing method for the current source 300 in Fig. 1 and Fig. 2. The P-N junction originally formed by the P-region 123 and the N-region 131 in these two figures is implemented in the P-region 140 shown in Fig. 5(a) or Fig. 6(a). Fig. 12(a) schematically shows the structure of this method. In this figure, the drain region of the n-MIS controlled by $G_2$ is an N-region 144, and a P-region 143 is implemented in the N-region 144, forming a P-N junction. The P-region 143 is connected to the P-region 123 by a conductor through FOC of this figure. Fig. 12(b) shows the simple equivalent circuit of Fig. 12(a).

Although the structures stated above can make the device being conduct, the time making the device from off-state to on-state may be very long. Because the precondition of holes in the P-region 101 injecting into the N-region 110 is that there should have electrons in the N-region 130 flowing through the P-region 121 then into the N-region 110, and eventually into the P-region 101, then out from the electrode A. This requires the voltage across the P-region 120 and the N-region 131 to be high enough (about 0.7V for Si devices), this voltage is produced in turn by the injection of holes from the P-region 101. This cycle process significantly increases the time to make the regeneration effect of the thyristor work.

To increase the turn-on speed, electrons can be introduced directly to the voltage-sustaining region 110 at the beginning of the turn-on process, instead of through the path from the N-region 130 to the P-region 121. Fig. 13(a) schematically shows a structure of this method based on the structure of Fig. 5(a), wherein n-region 110 serves as drain region, and a part of n$^+$-region 201 as source region. An insulator layer 161 covers on these two regions and p-region 122, n-region 132 and p-region 140 at surface and is covered by a conductor as the gate of an n-MIS, which is called as turning-on gate $G_{on}$. The turning-on gate $G_{on}$ is connected with $G_1$, forming two series n-MISs which share a gate signal. Both of them are turned on at the primary stage from off-state to on-state, and electrons flow into n-region 110. Since these two n-MIS are connected in series, the total electron currents are controlled by the gate $G_1$. Electron current can be equal to hole current (controlled by $G_2$) after turning on. Fig. 13(b) shows the simple equivalent circuit of Fig. 13(a).

In order to speed up the turn-on process further, different gate signals of $G_1$ and $G_{on}$ can be applied, the structure is shown in Fig. 14(a). Here, the N-region 130 serves as the source region, the P-region 121 serves as the substrate region, the N-region 110 serves as the drain region of the special turn-on n-MIS, and an insulator layer 162 is covered from a part of the N-region130 to a part of the N-region 110 and it's in turn covered by a conductor serves as a gate electrode $G_{on}$. Fig. 14(b) shows the simple equivalent circuit of Fig. 14(a).

A method to obtain the voltage applied to $G_{on}$ is proposed in the present invention. As shown in Fig. 15(a), an N$^+$-region 111 is implemented in the N-type voltage-sustaining region 110 at the boundary of a cell. When $V_{AK}$ is high but current is small, the N$^+$-region 111 is not fully depleted, and a positive voltage with respect to p-region 121 is generated in the un-depleted region. The un-depleted region is contacted to a conductor which is connected to $G_{on}$ through connection line. When $V_{AK}$ is small, the voltage of the un-depleted region with respect to the P-type region decreases. Therefore this region is suitable for the turn-on gate of $G_{on}$. Fig. 15(b) shows the simple equivalent circuit of Fig. 15(a).

In principle, the currents controlled by $G_1$ and $G_2$ can be reduced gradually during the process of turn-off in the present invention. However, such process costs a long time due to the regeneration effect caused by two transistors.

The speed of turn-off can be improved by using anode shorted structure, as shown in Fig. 4(c) and Fig. 4(d). It can be explained by that when the electron current flowing through the N-region 110 is very small, the voltage drop of the P-region 101 with respect to the N-region 102 is very low (e.g. it is lower than 0.5V for Si devices) and there is almost no holes injected into the N-region 110 from the P-region 101. At that time, the regeneration effect of transistors does not exist.

However, only when the current is small enough, the voltage drop across the P-region 101 and the N-region 102 can be reduced enough by using anode-short structure. In the present invention, a method for high speed of turn-off is also proposed, which is realized by adding a gate $G_{off}$ used for turn-off.

Fig. 16(a) shows schematically a method of adding a turn-off gate $G_{off}$ based on Fig. 14(a). An insulator layer 163 is covered on the top surface of semiconductor. The insulator layer is located from a part of the P-region 123 to a part of the P-region 140 through the N-region 132,a conductor is covered on such an insulator serving as the turn-off gate of a p-MIS, where the P-region 123, N-region 132 and P-region 140 are the source region, source substrate region and drain region, respectively. When the voltage applied to $G_{off}$ is lower than the threshold voltage, the p-MIS conducts, making the P-region 123 and P-region 140 conduct. If the voltage drop across the P-region 123 and P-region 140 is lower than the forward voltage drop of a P-N junction (about 0.7V for Si devices), there is almost no current flowing between the P-region 123 and N-region 131. In the same way, there is almost no current flowing between the P-region 121 and N-region 130. The two n-MISs controlled by $G_1$ and $G_2$ do not work and the device is equal to a PNP transistor composed of the P-region 101, N-region 110 and P-region 123 (as well as P-regions 121 and 122), which can sustain a very high voltage while nearly with no current. Fig. 16(b) shows the simple equivalent circuit of Fig. 16(a). Obviously, the method to ensure the voltage drop across the P-region 123 and P-region 140 lower than the forward voltage drop of a P-N junction (about 0.7V for Si devices) also can be realized by forming an n-MIS between the N-region 132 and P-region 140.

In practice, the two clamping diodes in Fig. 16, which are two series diodes composed of the P-N junction between p-region 122 and n-region 126 and the P-N junction between 141 and 142, are not necessary in the structure shown in Fig. 16(a). Because when the voltage applied to $G_{off}$ is enough to make the p-MIS conduct, the potential difference between p-region 121 (as well as p-regions 122 and 123) and p-region 140 is clamped. Fig. 17 schematically shows a structure without clamping diodes.

The effective method to increase turn-off speed, which is applied in the present invention, has been proposed in another patent (Ref. [1]) of the present inventor. Several specific structures are proposed in that patent, one of them shown in Fig. 21 of that patent is shown in Fig. 18 in the present invention, and the only difference between them is the marks of number. Here, p-region 602 and p-region 600 serve as voltage-sustaining structures at the junction termination. In the off-state, the voltage-sustaining region starts from the right side of p-region 601 which is connected to electrode K, and ends at the left side of a heavily doped n-region 400 which is the filed stop region. An insulator layer 661 is set on the surface of the right end of p-region 600 and covered by a conductor 080, which is connected to a resistor $R_i$. The other terminal of the resistor $R_i$ is connected to n-region 400. When a negative pulse signal is applied to the gate $G_0$ of this figure and results in a inversion region in the surface of n-region 110 beneath the insulator layer 660, the potential of p-region 602 and p-region 600 is to be closer to that of electrode K, thus the potential of the region underneath insulator 661 becomes lower than the value when no negative pulse signal is applied to $G_0$. Then the capacitor composed of 080 and the surface of semiconductor is to be charged. The current of the charging circuit starts from 400, flows through $R_j$ to 080, then to 600 and ends at electrode K. Therefore, there is a voltage drop across the resistor $R_j$ and a pulse of voltage with respect to the neutral n-region in 110 can be obtained at the terminal 810, which is connected to 080 and $R_j$.

The principle of producing a turn-off signal has been described above, while $n^+$-region 603, $n^+$-region 604, $p^+$-region 605 and FOC in this figure which are unrelated to the control method above, are not described here.

All in all, output signals with different polarity from 810 can be achieved at the moment of turning-on or before that and the moment of turning-off or before that. As shown in Fig. 19, a low-voltage circuit can be implemented in the neutral region 800 which locates out of the junction termination. Region 810 serves as the input terminal of this circuit, and electrodes A and B serve as the output terminals, which are connected to the electrodes A and B shown in the Fig. 4(e), respectively. When the device is turned off, the voltage between electrode A and B can be reduced to the value lower than the on-state voltage across a P-N junction (about 0.7V, for Si devices). Thus there are no longer holes from the lower surface injecting into n-region 110.

$C_0$ in Fig. 19 represents a power supply for the low-voltage circuit in region 800. This power supply is not required for the device with small current. But for devices with large current, at the beginning of turn-off process the current between electrodes A and B is very large, therefore high driven capability is required in the low-voltage circuit, thus a power supply which can provide large transient current is required. This power supply is illustrated by the capacitor $C_0$. A charging method for $C_0$ is proposed in the present invention. As shown in Fig. 20, in this figure, the dashed line stands for the boundary of depletion region in n-region 110 when the device is in off-state. The technique of JTT can be used in a part of p-region 600, which can be realized by the technique of OPtimized Variation Lateral Doping (OPVLD) described in Ref. [2]. There is a conductor contacted with a part of p-region 600 closer to the boundary of depletion region. Such conductor is connected to n-region 802 surrounded by p-region 801 in a neutral region. One terminal of $C_0$ is connected to p-region 801, and the other terminal is connected to $n^+$-region 803 in the neutral region of n-region 110. When $V_{AK}$ is very large (e.g. when the device is in off-state), there is a current flowing from $n^+$-region 803 to $C_0$, then through the P-N junction formed by p-region 801 and n-region 802, and then through 600 at the junction termination then towards into electrode K, which charges the capacitor. When the voltage drop across the capacitor reaches a certain value, the charging process will stop. The capacitor can be used as the power supply of the low-voltage circuit. The diode composed of p-region 801 and n-region 802 in this figure can prevent the automatic discharging of $C_0$, when this power supply is not used.

There are capacitors between two gates $G_1$ and $G_2$ and the surface of semiconductor, controlling the two n-MIS's during the process of turn-on and/or turn-off, which consume a large amount of power. So it is best to get a positive voltage with respect to electrode K from the device itself of the present invention, in order to reduce the requirement of external drive. In addition, during the process from off state to conduction state, if the voltage of p-region 121 is positive with respect to n-region 130 and negative to n-region 110, it will assist the electrons to flow into n-region 110 and then into p-region 101. This requires that the voltage of p-region 121 should be positive with respect to electrode K. A method for producing a positive voltage with respect to electrode K by the device itself is proposed in the present invention.

Fig. 21 (a) shows this method. There is a heavily doped $n^+$-region 111 in the surface of n-region 110 (see Ref. [3]). This region is connected to the surface of p-region 145 which is implemented in n-region 146 through a wire. An electrode F covers on the surface of n-146 and a capacitor $C_1$ is connected between electrode F and K. When $V_{AK}>0$,

electrons can flow from n$^+$-region 111 into n-region 110, then to the bottom surface. Therefore, there is current flowing into n$^+$-region 111 from the bottom surface, then through the P-N junction composed of 145 and 146, then to the capacitor C$_1$ through electrode F and then to electrode K, which charges C$_1$.

Note that, no matter which structure shown in Fig. 4 is used in the bottom, it is impossible for hole current to flowing constantly into the electrode K in this figure. This is because, the P-region 140 connected with the electrode K is surrounded by the N-region 132, and the latter is connected to the P-region 120 through the FOC at the surface. When the P-region 120 is charged by positive charges, the voltage drop across the P-N junction formed by the N-region 132 and P-region 140 is negative and this P-N junction is reverse biased. In addition, the voltage drop across the P-N junction formed by the N-region 146 and P-region 140 is negative after C$_1$ is charged.

Further, those skilled in the art can easily recognize that the capacitor in the present invention is not limited to be an external one, but can also be implemented in the chip, e.g. by forming a MIS capacitor.

The required gates voltage of G$_1$ and G$_2$ and the positive voltage of the P-region 121 (and P-regions 122 and 123) with respect to K discussed above can be easily obtained by applying external control signal due to that a positive power supply with respect to the electrode K can be realized inside the device. Fig. 21(b) schematically shows this. In this figure, there is a P-region 140 on the N-region 132 which is implemented on the P-region 120 (represents P-regions 121 or 122 or 123 or other regions like these), and a conventional low-voltage circuit can be implemented in the P-region 140. This low-voltage circuit has a power supply which is realized by connecting with the electrode K and F through wires. The output terminals with respect to electrode K of the low-voltage circuit include the ones for applying voltage to G$_1$ and G$_2$ and the one to P-region 120. The voltages of these output terminals are controlled by an external signal from an input terminal G$_c$.

A simulation result of the device shown in Fig. 22 is given in the following description. In this figure, the structure is the one shown in Fig. 14(a), the bottom of which is implemented by using the anode-short shown in Fig. 4(e). The interdigitated layout is applied and the impurity concentration [cm$^{-3}$], width [$\mu$m] and thickness [$\mu$m] of each region are given as below. For 110 region: $1 \times 10^{14}$, 57, 300; for 101 region: $3 \times 10^{18}$, 40, 2; for 102 region: $1 \times 10^{19}$, 17, 2; for 121 region: $5 \times 10^{16}$ 20, 10; for 122 region: $1 \times 10^{17}$, 17, 10; for 123 region: $5 \times 10^{17}$, 13, 10; for 130 region: $3 \times 10^{17}$ , 10, 2; for 131 region: $2 \times 10^{16}$, 10, 7; for 132 region: $1 \times 10^{17}$, 15, 4; the distance between the region 201 and region 202 is 0.3, the thickness of the region 260 is 0.03; the distance between the region 301 and region 302 is 0.3, the thickness of the region 360 is 0.03; the threshold voltage of both n-MOS's are 3V; the distance between the region 110 and region 130 beneath the region 162 is 5, the thickness of the region 162 is 0.03 and the threshold voltage of the n-MOS controlled by G$_{ON}$ is 1.4V. Models such as SRH, CONMOB, FLDMOB, IMPACT.I are used in the simulation, and both of lifetimes of the two types of carrier are set as 200$\mu$s.

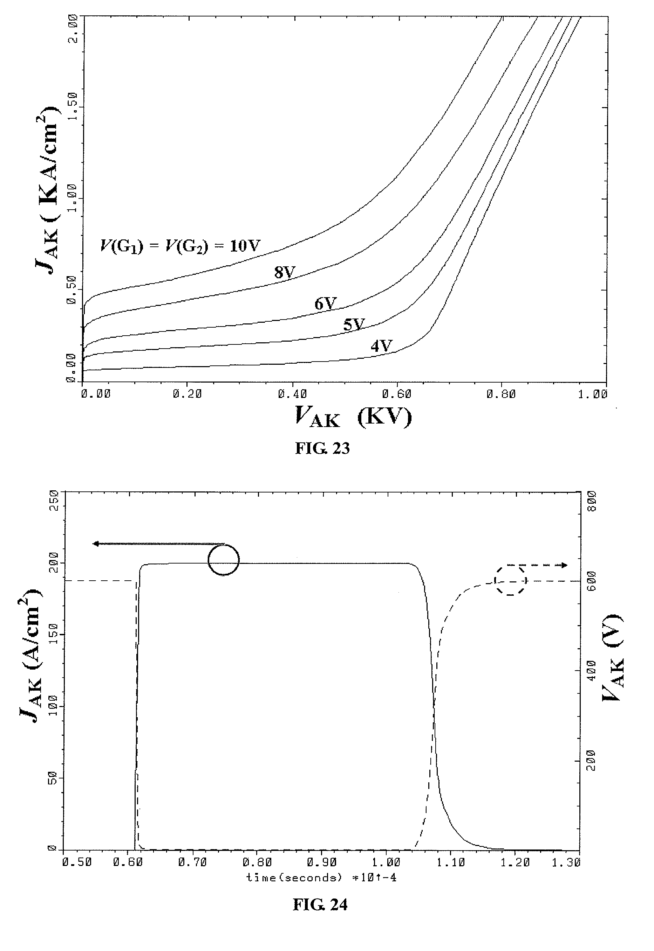

Fig. 23 shows the DC characteristic. Under the current density of the device J$_{AK}$ = 200A/cm$^2$, the on-state voltage is 1.35V. The breakdown voltage of the device is 1300V (at the condition that the anode-short is used and the voltages of the three gates are equal to the one of the electrode K).

Fig. 24 shows the switching characteristics simulated by using TMA-MEDICI package. According to this figure, the turn-on time is 0.45$\mu$s (taken for the current to rise from 10% to 90%) and the turn-off time is 4$\mu$s (taken for the current to fall from 90% to 10%).

Here, for the sake of convenience, an n-MOS is added between the electrodes A and B to replace the structures shown in Figs. 18, 19, 20. To turn on the device, the values of V(G$_{ON}$) and V(G$_1$) are firstly increased simultaneously from 0V to 10V linearly in 0.1$\mu$s, then after 20$\mu$s the value of V(G$_2$) is increased linearly from 0V to 10V in 3$\mu$s. In the turn-off process, the electrodes A and electrode B are shorted in 0.1$\mu$s at the beginning, at the same time, the value of V(G$_{ON}$) is decreased linearly from 10V to 0V in 0.1$\mu$s, then, after 1$\mu$s the values of V(G$_1$) and V(G$_2$) are decreased linearly from 10V to 0V in 10$\mu$s.

From the simulation results indicated above, the performance of the device has been better than the product SIGC156T120R2C (manufactured by Infineon, with current density smaller than 63A/cm$^2$, and on-state voltage 2.5V) and the current density of the present device is larger with the same on-state voltage. It should be noted that the design provided here is not an optimum one.

It is important to point out that the most likely reason to cause power devices failure is the current crowding effect. From the DC characteristic shown in Fig. 23, it can be understood that for the device proposed in this invention, an increasing of V$_{AK}$ or the gate voltage in any local cell causes larger current, but not uncontrollable, and electrical breakdown will not happen even with a high voltage of V$_{AK}$.

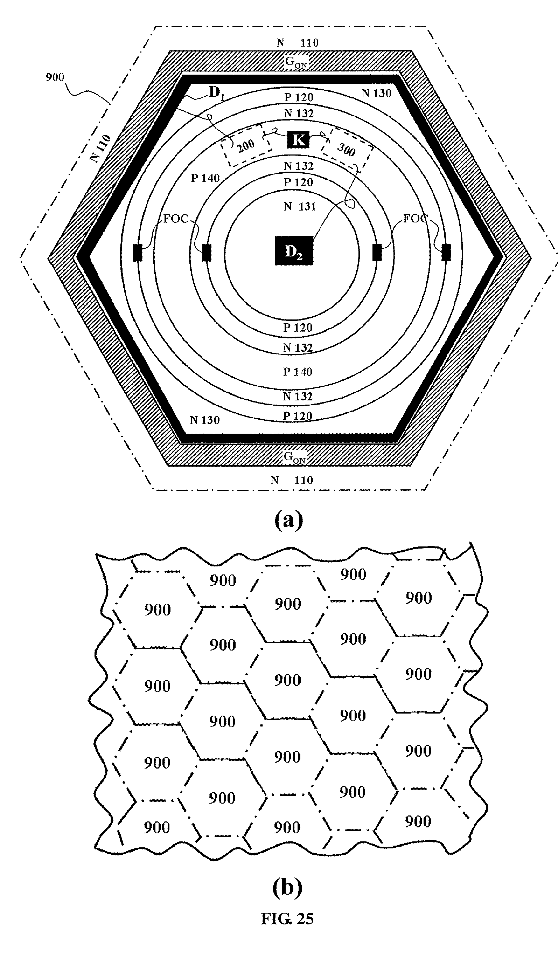

The structures of the cell described above also can be designed to other patterns besides the interdigitated layout. Fig. 25(a) schematically shows a pattern of hexagonal cell, wherein the N-region 110 exposed to the surface is designed at the edge of the cell to obtain a large turn-on capability. Fig. 25(b) schematically shows the close-packed of such cells.

Although an N-region is used to serve as voltage-sustaining region in the above description, it is evident that a P-region can be used to substitute the N-region as voltage-sustaining region. In that case, all of the N-regions and P-regions described above should be exchanged each other and electrodes A and K should also be exchanged.

Some examples of the present invention have been illustrated above. It should be understood that various other examples of application, which should be included in the scope of the present invention as defined in the claims, will be apparent to those skilled in the art.

Although the invention has been described and illustrated with reference to specific embodiments thereof, it is not intended that the invention be limited to these illustrative embodiments. Those skilled in the art will recognize that modifications and variations can be made without departing from the spirit of the invention. The object of choosing and describing the examples of the application of the present invention is for better explanation of the theory and practical applications. The examples chosen above are for those skilled in the art to understand the present invention and thus be able to design various applications with various modifications for special utilizations.

**Claims**

1. A semiconductor device, wherein the operation region of said device is located between a first main surface and a second main surface of a semiconductor, comprising cell(s) of any one kind or any two kinds or even all of three kinds, said cells of three kinds are cell of a first kind, cell of a second kind and cell of a third kind;
   wherein said cell of said first kind comprising

   a first semiconductor region of a first conductivity type serving as a main voltage-sustaining region;
   said first semiconductor region of a first conductivity type is connected to a first semiconductor region of a second conductivity type through a semiconductor region of a first conductivity type on one side;
   said first semiconductor region of a first conductivity type is contacted to a second semiconductor region of a second conductivity type on the other side;
   at least a portion on the opposite side of said second semiconductor region of a second conductivity type is contacted to a second semiconductor region of a first conductivity type;
   wherein said second semiconductor region of a first conductivity type is connected with a first terminal of a first controlled current source; another portion of said second semiconductor region of a second conductivity type is connected to a first terminal of a second controlled current source; both second terminals of said controlled current sources are connected with a first conductor, which is a first electrode;
   said second main surface has either of two connection methods:

   a first connection method is that only a second conductor is connected with said first semiconductor region of a second conductivity type, said second conductor is a second electrode;
   a second connection method is that besides said second conductor, there is a third conductor, connected with said first semiconductor region of a first conductivity type through a semiconductor region of a first conductivity type, said third conductor is a base electrode;

   said first controlled current source controls a current of carriers of first type flowing through said first semiconductor region of a first conductivity type, said second controlled current source controls a current of carriers of second type flowing through said first semiconductor region of a first conductivity type; a current through said first electrode to said second electrode is controlled by both two current sources;
   said cell of said second kind has not only the features of said cell of said first kind, but also has features wherein a portion of said first semiconductor region of a first conductivity type is contacted directly to a portion of said first main surface and is covered by a first insulator layer, said first insulator also covers on a place of said second semiconductor region of a second conductivity type and a place of said second semiconductor region of a first conductivity type on said first main surface, said first insulator layer is covered by a conductor; said portion of said first semiconductor region of a first conductivity type which is contacted directly to said first main surface and said second semiconductor region of a first conductivity type serve as a drain region and a source region of a Metal-Insulator-Semiconductor, MIS, of a first conductivity type, respectively, said second semiconductor region of a second conductivity type serves as a source-body region, said conductor covering on said first insulator serves as a gate of said MIS of a first conductivity type, a signal applied on said gate controls a current of a first conductivity type between said drain and said source of said MIS of a first conductivity type;
   said cell of said third kind has not only the features of the cell of said first kind, but also has features wherein a second insulator layer covers on said first main surface from a part of a second semiconductor region of a second conductivity type to the first side of a semiconductor region of a second conductivity type serving as junction edge termination region; the second side of said junction edge termination region is at a place of said first semiconductor region of a first conductivity type where no electric field exists even under very high voltage is applied across said first electrode and said second electrode; a conductor covers on said second insulator

12

layer serving as a turn-off gate; a low-voltage circuit is implemented outside of said second side of said junction edge termination region; said low-voltage circuit has two output terminals: a first one is connected with said second electrode and a second one is connected with said base electrode;

said low-voltage circuit has two input terminals, wherein a first input terminal is connected to said second side of said junction edge termination region where no electric field exists even under very high voltage is applied across said first electrode and said second electrode, a second input terminal is connected to a portion in said junction edge termination region but close to said second side, said second input terminal serves as a controlling terminal of said low-voltage circuit;

when a pulse signal is applied to said turn-off gate, a large current can flow between said two output terminals of said low-voltage circuit with a low voltage drop between said two output terminals, which prevents an injection of said carriers of second type from said first semiconductor region of a second conductivity type into said first semiconductor region of a first conductivity type;

when said region(s) of a first conductivity type is(are) N-type region(s), then said carrier(s) of first type are electron(s), said region(s) of a second conductivity type is(are) P-type region(s) and said carrier(s) of second type are hole(s); when said region(s) of a first conductivity type is(are) P-type region(s), then said carrier(s) of first type are hole(s), said region(s) of a second conductivity type are N-type region(s) and said carrier(s) of second type are electron(s).

2. A semiconductor device according to claim 1, wherein said third conductor is connected directly to said second electrode, not connected to said second output terminal of said low-voltage circuit.

3. A semiconductor device according to claim 1, wherein an area of said second semiconductor region of a second conductivity type up to said first main surface is divided into three sub-regions isolated one to another by said first semiconductor region of a first conductivity type; each sub-region has its own second semiconductor region of a first conductivity type surrounded individually by each sub-region of said second semiconductor region of a second conductivity type and said first main surface; wherein, in a first sub-region, a dose of doping of said second semiconductor region of a first conductivity type is much larger than a dose of doping of said second semiconductor region of a second conductivity type; in a second sub-region, a dose of doping of said second semiconductor region of a first conductivity type is much smaller than a dose of doping of said second semiconductor region of a second conductivity type;

wherein said second semiconductor region of a second conductivity type in third sub-region is connected with its own second semiconductor region of a first conductivity type by using floating ohmic contact on said first main surface; a third semiconductor region of a second conductivity type is surrounded by said second semiconductor region of a first conductivity type of said third sub-region and said first main surface, said third semiconductor region of a second conductivity type contains at least two Metal-Insulator-Semiconductor Field-Effect Transistors, MIS's, of a first conductivity type; two source regions of said two MIS's of a first conductivity type are connected through said first conductor to said third semiconductor region of a second conductivity type serving as a source-body region of both two MIS's of a first conductivity type; two drain regions of said two MIS's of a first conductivity type are connected with said second semiconductor regions of a first conductivity type of said first sub-region and of said second sub-region, respectively; at least two insulator layers are formed on said first main surface, each of them covers on a part of each drain region, a part of each source region and source-body region of each n-MIS, respectively; said two insulator layers are covered by two conductors serving as two gates of said two MIS's of a first conductivity type, controlling two currents of said two MIS's of a first conductivity type, respectively.

4. A semiconductor device according to claim 1, wherein an area of said second semiconductor region of a second conductivity type up to said first main surface is divided into three sub-regions isolated one to another by trenches filled with insulators; each sub-region has its own second semiconductor region of a first conductivity type surrounded individually by each sub-region of said second semiconductor region of a second conductivity type and said first main surface; wherein in a first sub-region, a dose of doping of said second semiconductor region of a first conductivity type is much larger than a dose of doping of said second semiconductor region of a second conductivity type, in a second sub-region, a dose of doping of said second semiconductor region of a first conductivity type is much smaller than a dose of doping of said second semiconductor region of a second conductivity type;

wherein said second semiconductor region of a second conductivity type in third sub-region is connected with its own second semiconductor region of a first conductivity type by using floating ohmic contact on said first main surface; a third semiconductor region of a second conductivity type is surrounded by its own second semiconductor region of a first conductivity type and said first main surface, said third semiconductor region of a second conductivity type contains at least two MIS's of a first conductivity type; two source regions of said two MIS's of a first conductivity type are connected through said first conductor to said third semiconductor region of a second conductivity type serving as a source-body region of both two MIS's of a first conductivity type; two drain regions of said two MIS's of a first conductivity type are connected with said second semiconductor regions of a first conductivity type of said first sub-region and of said second sub-region, respectively; at least two insulator layers are formed on said first main surface, each of them covers on a part of each drain region, a part of each source region and source-body region of each n-MIS, respectively; said two insulator layers are covered by two conductors serving as two gates of said two MIS's of a first conductivity type, controlling two currents of said two MIS's of a first conductivity type, respectively.

5. A semiconductor device according to claim 1, wherein an area of said second semiconductor region of a second conductivity type up to said first main surface is partly divided into three sub-regions, where divided parts are isolated one to another by trenches filled with insulators; each sub-region has its own second semiconductor region of a first conductivity type surrounded individually by each sub-region of said second semiconductor region of a second conductivity type and said first main surface; wherein in a first sub-region, a dose of doping of said second semiconductor region of a first conductivity type is much larger than a dose of doping of said second semiconductor region of a second conductivity type, in a second sub-region, a dose of doping of said second semiconductor region of a first conductivity type is much smaller than a dose of doping of said second semiconductor region of a second conductivity type;

wherein said second semiconductor region of a second conductivity type in third sub-region is connected with its own second semiconductor region of a first conductivity type by using floating ohmic contact on said first main surface; a third semiconductor region of a second conductivity type is surrounded by its own second semiconductor region of a first conductivity type and said first main surface, said third semiconductor region of a second conductivity type contains at least two MIS's of a first conductivity type; two source regions of said two MIS's of a first conductivity type are connected through said first conductor to said third semiconductor region of a second conductivity type serving as a source-body region of both two MIS's of a first conductivity type; two drain regions of said two MIS's of a first conductivity type are connected with said second semiconductor regions of a first conductivity type of said first sub-region and of said second sub-region, respectively; at least two insulator layers are formed on said first main surface, each of them covers on a part of each drain region, a part of each source region and source-body region of each MIS of a first conductivity type, respectively; said two insulator layers are covered by two conductors serving as two gates of said two MIS's of a first conductivity type, controlling two currents of said two MIS's of a first conductivity type, respectively.

6. A semiconductor device according to claim 1, wherein an area of said second semiconductor region of a second conductivity type up to said first main surface is divided into three sub-regions connected each other; each sub-region has its own second semiconductor region of a first conductivity type surrounded individually by each sub-region of said second semiconductor region of a second conductivity type and said first main surface; wherein, in a first sub-region, a dose of doping of said second semiconductor region of a first conductivity type is much larger than a dose of doping of said second semiconductor region of a second conductivity type; in a second sub-region, a dose of doping of said second semiconductor region of a first conductivity type is much smaller than a dose of doping of said second semiconductor region of a second conductivity type;

wherein said second semiconductor region of a second conductivity type in third sub-region is connected with its own second semiconductor region of a first conductivity type by using floating ohmic contact on said first main surface; a third semiconductor region of a second conductivity type is surrounded by its own second semiconductor region of a first conductivity type and said first main surface, said third semiconductor region of a second conductivity type contains at least two MIS's of a first conductivity type; two source regions of said two MIS's of a first conductivity type are connected through first conductor to said third semiconductor region of a second conductivity type serving as a source-body region of both two MIS's of a first conductivity type as well; two drain regions of said two MIS's of a first conductivity type are connected with said second semiconductor regions of a first conductivity type of said first sub-region and of said second sub-region, respectively; at least two insulator layers are formed on said first main surface, each of them covers on a part of each drain region, a part of each source region and source-body region of each n-MIS, respectively; said two insulator layers are covered by two conductors serving as two gates of said two MIS's of a first conductivity type, controlling two currents of said two MIS's of a first conductivity type, respectively.

7. A semiconductor device according to claims 3-6, wherein said second semiconductor region of a first conductivity type in said second sub-region is connected with an additional semiconductor region of a second conductivity type in said second semiconductor region of a first conductivity type through a conductor.

8. A semiconductor device according to claim 1, wherein a connection method of said another portion of said second semiconductor region of a second conductivity type to said first terminal of said second controlled current source is what follows:

a second semiconductor region of a first conductivity type surrounded by said second semiconductor region of a second conductivity type and said first main surface, and both regions are connected through a floating ohmic contact on said first main surface; a third semiconductor region of a second conductivity type is surrounded by said second semiconductor region of a first conductivity type and said first main surface; at least two MIS's of a first conductivity type are implemented in said third semiconductor region of a second conductivity type; two source regions of said MIS's of a first conductivity type are connected with said third semiconductor region of a second conductivity type, which serves as a source-body region of said MIS's of a first conductivity type, through a conductor serving as said first electrode on said first main surface; a semiconductor region of a second conductivity type are surrounded by one of two drain regions of said MIS's of a first conductivity type and said first main surface, and is connected through a conductor to a second semiconductor region of a second conductivity type; at least two insulator layers are covered on said first main surface, each one is started from a part of a drain region via a third semiconductor region of a second conductivity type as source-body region and ended at a part of a source region; said two insulator layers are covered by conductors serving as gates of said two MIS's of a first conductivity type and control currents through said two MIS's of a first conductivity type, respectively.

9. A semiconductor device according to claim 1, wherein said current sources are implemented in said third semiconductor region of a second conductivity type which is isolated with other regions.

10. A semiconductor device according to claim 1, wherein said gate in said cell of said second kind is connected to a heavily doped first semiconductor region of a first conductivity type located beneath said first main surface through a conductor.

11. A semiconductor device according to claim 3 or claim 4, or claim 5 or claim 6, or claim 10, wherein a MIS is formed for helping conduct said second semiconductor region of a second conductivity type and said third semiconductor region of a second conductivity type;
said MIS has either of two implement methods:

a first implement method is that said second sub-region of second semiconductor region of a second conductivity type serves as a source region, said second semiconductor region of a first conductivity type serves as a substrate region and said third semiconductor region of a second conductivity type serves as a drain region of said MIS of a second conductivity, respectively;
a second implement method is that a semiconductor region of a first conductivity type in said third semiconductor region of a second conductivity type in said third sub-region serves as a source region, said third semiconductor region of a second conductivity type in said third sub-region serves as a substrate region and said second semiconductor region of a first conductivity type in said third sub-region serves as a drain region of said MIS, respectively;
an insulator covers on said first main surface starting from a part of said source region, via said substrate region and ending at a part of drain region of said MIS; said insulator is covered by a conductor serving as a gate of said MIS, a voltage applied on said gate makes said MIS turn on.

12. A semiconductor device according to claim 4 or claim 5, or claim 6 or claim 8, or claim 9 or claim 11, wherein at least two series clamping diodes are implemented between said second semiconductor region of a second conductivity type and said third semiconductor region of a second conductivity type.

13. A semiconductor device according to claim 1, wherein in said cell of said first kind, a semiconductor region of a first conductivity type having a large dose of doping is contacted with said first semiconductor region of a first conductivity type, a conductor is covered on said semiconductor region of a first conductivity type having a large dose of doping; said second semiconductor region of a second conductivity type is connected through floating ohmic contact on said first main surface with a second semiconductor region of a first conductivity type inside of it; a third semiconductor region of a second conductivity type is inside said second semiconductor region of a first conductivity type; a third semiconductor region of a first conductivity type is surrounded by said third semiconductor region of a second conductivity type and said first main surface; a fourth semiconductor region of a second conductivity type is surrounded by said third semiconductor region of a first conductivity type, and is contacted with a conductor connected to said conductor covering on said first semiconductor region of a first conductivity type having a large dose of doping; said third semiconductor region of a first conductivity type is contacted with a conductor connecting with one terminal of a capacitor, another terminal of said capacitor is connecting with said first electrode; said capacitor serves as a power supply of a low-voltage circuit implemented in said third semiconductor region of a second conductivity type; where at least one input terminal of said low-voltage circuit receive external applied signal and output terminals of said low-voltage circuit can be applied for controlling said two current sources and/or can be connected to said second semiconductor region of a second conductivity type.

14. A semiconductor device according to claim 1, wherein: a conductor is contacted to a portion of said junction edge termination region close to its second side on the first main surface; said conductor is connected to another conductor on said first main surface contacted with a semiconductor region of a first conductivity type surrounded by a semiconductor region of a second conductivity type except at said first main surface and located outside of said second side of said junction edge termination region;
a terminal of a capacitor is connected to a first semiconductor region of a first conductivity type located outside of said junction edge termination region, another terminal of said capacitor is connected to said semiconductor region of a second conductivity type located outside of said second side of said junction edge termination region;
said capacitor serves as a power-supply to a low-voltage circuit outside said second side of said junction edge termination region.

15. A semiconductor according to claim 12, wherein: a semiconductor region of a first conductivity type is surrounded by said second semiconductor region of a second conductivity type and said first main surface, forming a first diode; a semiconductor region of a second conductivity type is surrounded by a semiconductor region of a first conductivity type in said third semiconductor region of a second conductivity type, forming a second diode; said semiconductor region of a first conductivity type of said second diode is connected with said third semiconductor region of a second conductivity type by using floating ohmic contact; said semiconductor region of a first conductivity type of said first diode is connected with said semiconductor region of a second conductivity type of said second diode.

**FIG. 1**

**FIG. 2**

**(a)**                                                    **(b)**

FIG. 3

FIG. 4

(a)

(b)

FIG. 5

**(a)**

**(b)**

FIG. 6

FIG. 7

FIG. 8

FIG. 9

FIG. 10

(a)

(b)

FIG. 11

(a)

(b)

FIG. 12

(a)

(b)

FIG. 13

**(a)**

**(b)**

**FIG. 14**

**(a)**

**(b)**

**FIG. 15**

**(a)**

**(b)**

FIG. 16

**FIG. 17**

**FIG. 18**

810    $C_0$    A  B

400

N

low-voltage circuit region
800

junction edge-termination

N    110

P    101        N    102

A        B

FIG. 19

K

802    801

400    802    803

P    600        N    802    $C_0$
P    801    N

active device region  junction edge-termination

N    110

P    101        N    102

A        B

FIG. 20

FIG. 21

FIG. 22

FIG. 23

FIG. 24

**(a)**

**(b)**

**FIG. 25**

# INTERNATIONAL SEARCH REPORT

| International application No. |
|---|
| PCT/CN2011/083710 |

## A. CLASSIFICATION OF SUBJECT MATTER

See the extra sheet

According to International Patent Classification (IPC) or to both national classification and IPC

## B. FIELDS SEARCHED

Minimum documentation searched (classification system followed by classification symbols)

IPC: H01L

Documentation searched other than minimum documentation to the extent that such documents are included in the fields searched

Electronic data base consulted during the international search (name of data base and, where practicable, search terms used)

CNPAT, CNKI, EPODOC, WPI: semiconductor, N-Zone, P-Zone, current source, "P", "N", hole, current concentration effect, control, thyristor, current, source, control, adjust+, regulat+, carrier

## C. DOCUMENTS CONSIDERED TO BE RELEVANT

| Category* | Citation of document, with indication, where appropriate, of the relevant passages | Relevant to claim No. |
|---|---|---|
| A | CN 101494239 A (UNIVERSITY OF ELECTRONIC SCIENCE AND TECHNOLOGY OF CHINA), 29 July 2009 (29.07.2009), see description, page 1, lines 8-17, page 8, lines 8-19, and page 10, line 29 to page 11, line 25, and figures 1, 3 and 7 | 1-15 |
| A | EP 0581246 A2 (FUJI ELECTRIC CO., LTD. (JP)), 02 February 1994 (02.02.1994), see the whole document | 1-15 |
| A | DE 1817497 A1 (IBM DEUTSCHE INTERNATIONALE BU), 16 July 1970 (16.07.1970), see the whole document | 1-15 |
| A | JP 7221281 A (TOYODA AUTOMATIC LOOM WORKS), 18 August 1995 (18.08.1995), see the whole document | 1-15 |

☐ Further documents are listed in the continuation of Box C.     ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 13 February 2012 (13.02.2012) | 15 March 2012 (15.03.2012) |

| Name and mailing address of the ISA/CN: State Intellectual Property Office of the P. R. China No. 6, Xitucheng Road, Jimenqiao Haidian District, Beijing 100088, China Facsimile No.: (86-10) 62019451 | Authorized officer MA, Shanshan Telephone No.: (86-10) 62411814 |
|---|---|

Form PCT/ISA/210 (second sheet) (July 2009)

### INTERNATIONAL SEARCH REPORT
Information on patent family members

| International application No. |
|---|
| **PCT/CN2011/083710** |

| Patent Documents referred in the Report | Publication Date | Patent Family | Publication Date |
|---|---|---|---|
| CN 101494239 A | 29.07.2009 | US 2010219446 A1 | 02.09.2010 |
| | | CN 101494239 B | 01.12.2010 |
| EP 0581246 A2 | 02.02.1994 | JP 6125078 A | 06.05.1994 |
| | | EP 0581246 A3 | 24.08.1994 |
| | | US 5714774 A | 03.02.1998 |
| | | EP 0581246 B1 | 03.03.1999 |
| | | DE 69323665 E | 08.04.1999 |
| | | JP 3163820 B2 | 08.05.2001 |
| DE 1817497 A1 | 16.07.1970 | DE 1817497 B2 | 26.06.1980 |
| | | DE 1817497 C3 | 19.06.1981 |
| JP 7221281 A | 18.08.1995 | None | |

Form PCT/ISA/210 (patent family annex) (July 2009)

# INTERNATIONAL SEARCH REPORT

| International application No. |
| --- |
| **PCT/CN2011/083710** |

**A. CLASSIFICATION OF SUBJECT MATTER**

H01L 29/74 (2006.01) i
H01L 21/332 (2006.01) i

**REFERENCES CITED IN THE DESCRIPTION**

**Patent documents cited in the description**

- US 71258310 A, X. B. Chen
- CN ZL200910119961
- US 5726469 A
- CN ZL95108317
- CN ZL201010000034